# EUROPEAN PATENT APPLICATION

(11) **EP 1 698 935 A2**
(43) Date of publication of application: **06.09.2006**
(21) Application number: 06251061.5
(22) Date of filing: 28.02.2006
(51) Int. Cl.: G03F 7/038

(54) **Negative-type photosensitive resin composition**

(30) Priority: 01.03.2005 JP 2005056106
(71) Applicant: Rohm and Haas Electronic Materials, L.L.C., Marlborough, Massachusetts 01752 (US)
(72) Inventor: Arao, Kei, Niigata-shi, Niigata 950-0074 (JP); Nomura, Makoto, Niigata-shi, Niigata 950-0851 (JP)
(74) Representative: Kent, Venetia Katherine

(57) **Abstract**

Provided are negative-type photosensitive resin compositions which may be used in forming interlayer insulating layers on a silicon wafer or printed wiring board. The compositions include a vinylphenol resin, a biphenyl-phenol resin and epoxy-containing materials. Also provided are methods of forming patterned dielectric films using such compositions. The resin compositions can be used in the manufacture of wafer-level chip-scale packages and LSIs, for example, as interlayer insulating layers.

## Description

The present invention relates to negative-type photosensitive resin compositions containing a phenol resin and epoxy-containing materials, and to methods of forming patterned dielectric layers using the negative-type photosensitive resin compositions.

Conventionally, epoxy resin compositions containing an epoxy resin and a vinylphenol resin have been used as sealing materials for semiconductor devices, such as ICs and LSIs, in view of their reliability as sealing materials. To obtain improved physical properties, a photosensitive resin obtained by adding an epoxy compound to a resin such as a conventional phenol resin has been proposed in manufacturing a wafer level-chip scale package (WL-CSP). Such photosensitive resin compositions, however, exhibit low solubilities in commonly used organic alkaline developers, such as aqueous solutions of tetramethylammonium hydroxide (TMAH). The low solubilities of the resin compositions can create difficulties in the developing process wherein a desired pattern is formed in a layer formed from the composition. Therefore, it is desired to provide photosensitive resin compositions which are capable of retaining desired physical and chemical properties, for example, thermal impact resistance, when used as an interlayer insulating resin or as a resist resin, and which overcome the above-mentioned problem.

Japanese patent publication No. 1993-273753 discloses a photoimageable composition comprising a phenol resin, an epoxy resin, a melamine resin, and a photoacid generator, which may be developed with an aqueous developer. This composition can provide a desired image by exposure to activating radiation and is developed with a solution of an inorganic alkaline such as sodium hydroxide.

Japanese patent publication No. 2004-240213 discloses a photosensitive resin composition prepared by adding biphenyl-phenol resin to a photosensitive resin composition comprising a novolak-containing material and an epoxy-containing material. The photosensitive resin composition purportedly exhibits improved thermal impact resistance, while retaining a photoimageable property. However, this composition should be developed with a solution of an inorganic alkaline, such as potassium hydroxide, and cannot be developed with an organic alkaline solution such as an aqueous TMAH solution, for example, a 2.38 % TMAH aqueous solution such as commonly used in the art.

Japanese patent publication No. 2004-233693 discloses a photosensitive resin composition which may be developed with an aqueous alkaline solution, such as an aqueous TMAH solution to provide a desired pattern. This composition is obtained by adding biphenyl-phenol resin to a photosensitive resin composition comprising a poly(*p*-vinylphenol) and an epoxy-containing material. This photosensitive resin composition purportedly provides an improved photoimageable property as compared to a conventional composition. However, a cured resin obtained by curing the remaining resin after the developing step does exhibit sufficient thermal impact resistance.

Through the invention, the inventors have provided photosensitive resin compositions and methods of forming patterned insulating layers which address one or more problems associated with the state of the art.

In accordance with a first aspect, the present invention provides negative-type photosensitive resin compositions. The compositions include a vinylphenol resin, a biphenyl-phenol resin and two or more epoxy-containing materials. The compositions may, for example, include three or more epoxy-containing materials.

In accordance with a second aspect, the present invention provides methods of forming patterned dielectric films. The methods involve: (a) forming a film on a substrate, the forming comprising applying a negative-type photosensitive resin composition to a substrate, wherein the composition comprises a vinylphenol resin, a biphenyl-phenol resin and two or more epoxy-containing materials; (b) exposing the film; and (c) developing the exposed film to form a patterned dielectric film.

The photosensitive resin compositions of the invention are capable of retaining their photoimageable properties while exhibiting improved thermal impact resistance by use of a combination of epoxy-containing materials. The compositions may be developed with commonly used aqueous alkali developer solutions such as TMAH solutions. The photosensitive resin compositions may beneficially be used, for example, as an interlayer insulating resin in a print wiring board or in a wafer level chip-sized package (WL-CSP).

The negative-type photosensitive resin compositions of the present invention contain two or more epoxy-containing materials. The epoxy-containing materials used in the present invention are any organic compound having one or more, typically two or more, oxirane rings which are polymerizable by a ring-opening reaction. This material is commonly known as an epoxide, including monomer epoxy compounds; and oligomer or polymer epoxides which may be aliphatic, alicyclic, aromatic, and heterocyclic. The polymer epoxide may include linear polymers having terminal epoxy groups, such as polyoxyalkylene glycol diglycidyl ethers; polymers containing backbone oxirane units, such as polybutadiene polyepoxides; or polymers containing epoxy group(s) in the side chain of the polymer, such as glycidyl methacrylate polymers or copolymers. The epoxide may be a pure compound, but is typically a mixture containing compounds with 1, 2 or more epoxy groups per molecule. Suitable epoxy-containing materials include, for example, low molecular weight monomer materials or oligomers, and high molecular weight polymers. The epoxy-containing materials may have various backbones and substituents. For example, the backbone may be any type of a polymer chain, and the substituent may be any group which has no substituent capable of being reacted with an oxirane ring at room temperature. Examples of suitable substituents include halogen atoms, ester groups, ether groups, sulfonate groups, siloxane groups, nitro groups, and phosphate groups.

An exemplary epoxy-containing material useful in the present invention is a liquid bisphenol epoxy-containing material. As used herein, the bisphenol epoxy-containing material refers to compounds prepared through the reaction of a bisphenol polyvalent phenol with an excess amount of chlorohydrin (such as epichlorohydrin), for example, diglycidyl ether of 2,2-bis-(2,3-epoxy-propoxyphenol)-propane. A suitable bisphenol epoxy-containing material is a bisphenol A epoxy-containing material prepared through the reaction of a bisphenol A with epichlorohydrin. More typically, the epoxy-containing material is a compound represented by the following general formula (I): 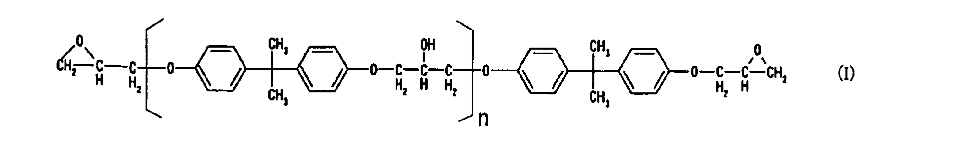 wherein, n = 0 to 2, typically n = 0 to 1, more typically n = 0.

Examples of the epoxy-containing material include bisphenol A epoxy resins such as EPIKOTE 825, 827, 828, 1001, 1002 (Japan Epoxy Resins Co.), and DER-331, DER-332, and DER-334 (Dow Chemical Co.). Other bisphenol epoxy-containing materials include bisphenol F epoxy resin, such as EPIKOTE 806, 807 (Japan Epoxy Resins Co.).

Another epoxy-containing material useful in the present invention is a polyalkyleneoxylated epoxy-containing material. One suitable embodiment of the negative-type photosensitive resin composition of the present invention comprises a bisphenol epoxy-containing material and a polyalkyleneoxylated epoxy-containing material. As used herein, a "polyalkyleneoxylated epoxy-containing material" refers to a compound in which a hydrocarbon group having ether linkage is bonded to an oxygen atom which is directly bonded to an aromatic ring of an aromatic hydrocarbon group which is a component of the epoxy-containing material. For the term "a hydrocarbon group having ether linkage", an oxygen atom which is a component of the "ether linkage" does not include the oxygen atom which is directly bonded to the aromatic ring of the aromatic hydrocarbon group. In addition, in said compound, the hydrocarbon group having the ether linkage may have one or a plurality of ether linkages. For example, the polyalkyleneoxylated epoxy-containing material may include a compound in which plural aromatic hydrocarbon groups are bonded to a hydrocarbon group having repeating units of alkyleneoxy groups. At least one hydrocarbon group having an ether linkage can exist in one molecule. Typically, all of the structures bonding aromatic hydrocarbon groups are bonded with the hydrocarbon group having an ether linkage. The polyalkyleneoxylated epoxy-containing material can comprise an epoxy resin in which a hydrocarbon group having an ether linkage is bonded to a ring carbon of an aromatic ring of a phenol resin having a glycidyl group via an acetal linkage. A typical hydrocarbon group having an ether linkage can include a hydrocarbon group having repeating units of a group having a structure of -R-O-R'- (wherein each of R and R' is a hydrocarbon group, which can be the same as or different from each other) or an alkyleneoxy group. Typically, the hydrocarbon group can be one which has two or more repeating units of alkyleneoxy groups. For example, typical groups can include a group prepared by an addition polymerization reaction of alkyleneoxide, such as an ethyleneoxyethyl group, a propyleneoxypropyl group, a poly(ethyleneoxy)ethyl group, a poly(propyleneoxy)propyl group, or a group prepared by an addition polymerization of ethyleneoxide and propyleneoxide. For example, flexible and tough epoxy resins, such as EPICLON EXA 4850 (Dainippon Ink and Chemicals, Inc.) are suitable.

Typically, the polyalkyleneoxylated epoxy-containing material can be an epoxy resin prepared by reacting a chlorohydrin with a phenol resin, wherein the phenol resin is prepared by polyalkyleneoxylating a bisphenol A resin with a hydrocarbon group having an ether linkage. More typical is an epoxy resin having a structure in which a bisphenol A resin is bonded through repeating units of alkyleneoxy groups. An exemplary epoxy resin has the following structure (II): 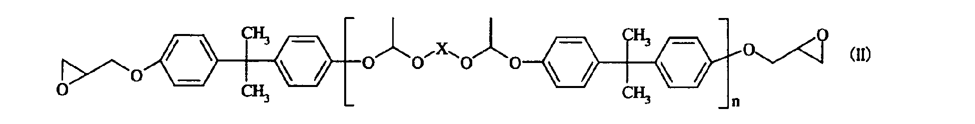 wherein, n = 1 to 7, for example, n = 2 to 5; and X= -R-O-R'-, wherein R and R' are alkylene groups which may be the same as or different from each other.

In the present invention, epoxy-containing materials of "at least two epoxy-containing materials" may include other epoxy-containing materials. For example, the other epoxy-containing materials which can be used in the present invention include an aromatic epoxy resin in which the distance between aromatic hydrocarbons is extended using a group having an ester linkage or (C₄-C₂₀) alkylene group, as well as aliphatic hydrocarbon epoxy resins, alicyclic hydrocarbon epoxy resins, phenol novolak epoxy resins, cresol novolak resins, biphenyl epoxy resins, and modified epoxy resins such as combinations thereof.

In one embodiment of the present invention, the negative-type photosensitive resin composition can comprise a bisphenol epoxy-containing material and an aromatic epoxy-containing material in which the distance between aromatic hydrocarbons is extended using a group having an ester linkage. Such aromatic epoxy-containing materials can include, for example, a resin having two or more, typically three or more, more typically four or more, repeating units of ester linkages of an aromatic hydrocarbon group having polyfunctional groups and an organic acid. The group having an ester linkage may have one or more ester linkages. The aromatic epoxy-containing material may include an epoxy resin prepared by reacting liquid bisphenol A resin with a dimer acid or an aliphatic dicarboxylic acid as a molecular chain extension agent.

In another embodiment of the present invention, the negative-type photosensitive resin composition may comprise a bisphenol epoxy-containing material and an aromatic epoxy-containing material in which the distance between aromatic hydrocarbons is extended using a (C₄-C₂₀) alkylene group. Such aromatic epoxy-containing material may include an epoxy resin in which two aromatic hydrocarbons groups having a glycidyl ether group are bonded through a (C₄-C₂₀) linear alkylene group, or in which a (C₄-C₂₀) linear alkylene group is bonded to aromatic hydrocarbon groups through an acetal group.

In one exemplary embodiment of the present invention, the negative-type photosensitive resin composition may comprise a third epoxy-containing material in addition to and which differs from the above-described two epoxy-containing materials. Typically, the third epoxy-containing material may include an alicyclic hydrocarbon epoxy resin, such as dicyclopentadiene glycidyl ether. Concrete examples are described, for example, in U.S. Patent No. 3,018,262. The third epoxy resin may include epichlorohydrin, glycidol, glycidyl methacrylate, *p*-tertbutylphenol glycidyl ether, such as EPI-REZ 5014 (Celanese Co.); dicyclopentadiene diglycidyl ether, such as ADEKA RESIN EP-4088S (Asahi Denka Co.); vinylcyclohexene dioxide, such as ERL-4206 (Union Carbide Corp.); 3,4-epoxy-6-methyl-cyclohexylmethyl-3,4-epoxy-6-methylcyclohexene carboxylate, such as ERL-4201 (Union Carbide Corp.); bis(3,4-epoxy-6-methyl-cyclohexylmethyl) adipate, such as ERL-4289 (Union Carbide Corp.); bis(2,3-epoxycyclopentyl) ether, such as ERL-0400 (Union Carbide Corp.); polypropylene-glycol-modified aliphatic epoxy, such as ERL-4050 and ERL-4269 (Union Carbide Corp.), dipentene dioxide, such as ERL-4269 (Union Carbide Corp.); nonflammable epoxy resin, such as brominated bisphenyl epoxy resin, such as DER-580 (Dow Chemical Co.); 1,4-butanediol diglycidyl ether of phenol formaldehyde novolak, such as DEN-431 and DEN-438 (Dow Chemical Co.); and resorcinol diglycidyl ether, such as KOPOXITE (Koppers Company, Inc.).

In an exemplary embodiment of the present invention, the negative-type photosensitive resin composition may comprise a bisphenol epoxy-containing material, a polyalkyleneoxylated epoxy-containing material and an alicyclic hydrocarbon epoxy-containing material.

The photosensitive resin compositions of the present invention in a cured state can exhibit significantly improved thermal impact resistance since the composition comprises two or more, for example, three or more epoxy-containing materials. That is, since the photosensitive resin composition of the present invention comprises a phenol epoxy-containing material and a polyalkyleneoxylated epoxy-containing material, the composition can be developed by 2.38 % by weight aqueous TMAH solution, and the thermal impact resistance of the cured resin can be improved. In addition, where the photosensitive resin composition further comprises an epoxy resin having an alicyclic hydrocarbon structure, thermal impact resistance of the cured resin can be further improved.

In the negative-type photosensitive resin compositions of the present invention, when an epoxy-containing material comprises a bisphenol epoxy-containing material and a polyalkyleneoxylated epoxy-containing material, the content of the bisphenol epoxy-containing material may be 30-95 % by weight, typically 50-85 % by weight, more typically 65-80 % by weight, based on the total weight of the epoxy containing-materials.

When the photosensitive resin compositions of the present invention comprise three or more epoxy-containing materials, the compositions typically comprise a bisphenol epoxy-containing material, a polyalkyleneoxylated epoxy-containing material and an alicyclic hydrocarbon epoxy resin. The mixing weight ratio of those epoxy-containing materials ([bisphenol epoxy-containing material]: [polyalkyleneoxylated epoxy-containing material]:[alicyclic hydrocarbon epoxy resin]) is typically 30-90:1-60:1-45, for example, 40-80:10-45:5-35, more typically 60-70:20-30:10-20, based on the total weight of the epoxy-containing materials.

The negative-type photosensitive resin compositions contain a vinylphenol resin. Typical vinylphenol resins of the present invention include poly(*p*-vinylphenol) resins, which are polymers containing *p*-vinylphenol as a polymerized unit. There is no particular limitation on the polymer as long as it contains no epoxy group. Typically, the polymer contains 50 % by weight or more ofp-vinylphenol as the polymerized units, based on the total polymerized units of the polymer. More typically, the polymer contains 75 % by weight or more of *p*-vinylphenol, and still more typically, 90 % by weight or more ofp-vinylphenol. Most typically, the polymer is a *p*-vinylphenol homopolymer, in which the polymerized units of the polymer are all *p*-vinylphenol.

The weight-average molecular weight of the poly(*p*-vinylphenol) is typically 2,000-40,000, and more typically 5,000-35,000.

The poly(*p*-vinylphenol) polymers may contain polymerized units other than *p-*vinylphenol. Examples of the copolymerizable compound include, but are not limited to, esters of acrylic acid or methacrylic acid, such as methyl acrylate, methyl methacrylate, hydroxyethyl acrylate, butyl methacrylate, octyl acrylate, 2-ethoxyethyl methacrylate, *t*-butyl acrylate, 1,5-pentanediol diacrylate, *N,N*-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2,2-di(p-hydroxyphenyl)-propane dimethacrylate, triethylene glycol dimethacrylate, polyoxypropyl trimethylolpropane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenylethylene-1,2-dimethacrylate, pentaerythritol tetramethacrylate, trimethylolpropane trimethacrylate, 1,5-pentanediol dimethacrylate, and 1,4-benzenediol dimethacrylate; styrene and substituted styrenes such as 2-methylstyrene and vinyltoluene; vinyl esters, such as vinyl acrylate and vinyl methacrylate; vinylphenols, such as o-vinylphenol and m-vinylphenol.

The poly(*p*-vinylphenol) can be prepared by methods known in the art. Commercially available products, such as MARUKA LYNCUR M S4P (Maruzen Petrochemical Co.), may be used.

The negative-type photosensitive resin compositions contain a biphenyl-phenol resin. As used herein, the term "biphenyl-phenol resin" refers to a polymer including phenol and biphenyl repeating units, which may be polymerized in any order. The polymer may also contain an alkylene structure such as methylene and ethylene units in addition to phenol and biphenyl repeating units. The biphenyl and phenol of the biphenyl-phenol resin may be substituted by a substituent, such as an alkyl group, an alkoxy group. The biphenyl-phenol resin includes no epoxy group. The biphenyl-phenol resin can be prepared by methods known in the art. Commercially available products, such as Phenol Resin MEH-7851 (Meiwa Kasei Co.), may be used.

Typically, the biphenyl-phenol resin has a structure represented by following formula (III): 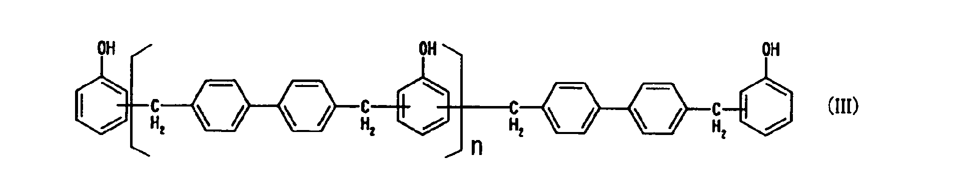 wherein, n = 0-4, typically n = 0-3, and more typically n = 0-1.

The number-average molecular weight of the biphenyl-phenol resin is typically 350-1200, and more typically 370-1000.

The content of the biphenyl-phenol resin is typically 5-45 % by weight, and more typically 10-40 % by weight, based on the total weight of the poly(*p*-vinylphenol) resin and the biphenyl-phenol resin.

Optionally, the negative-type photosensitive resin composition may contain additional resin binders which do not have an epoxy group, in addition to the above described poly(*p-*vinylphenol) resin and biphenyl-phenol resin. The additional resin binders may be any compound capable of bringing about a photoinitiated crosslinking reaction with one or more components in the negative-type photosensitive resin composition. Examples of suitable such resins include, but are not limited to, compounds comprising a functional group having one or more reactive moieties, such as a reactive hydrogen atom, including phenol/aldehyde condensation polymers known as novolak resins, alkenylphenol homopolymers or copolymers, partially hydrogenated novolak resins, and *N*-hydroxyphenylmaleimide homopolymers or copolymers.

In the negative-type photosensitive resin compositions, the content of the additional resin binder is typically 50 % by weight or less, more typically 25 % by weight or less, based on the total weight of the poly(*p*-vinylphenol), the biphenyl-phenol resin and the other resin binders. Most typically, the negative-type photosensitive resin composition does not contain any additional resin binder.

When the negative-type photosensitive resin composition contains a novolak resin as an additional resin binder (wherein the novolak resin does not include biphenyl-phenol resin), the content of the novolak resin should be less than 10 % by weight, typically less than 5 % by weight, based on the total weight of the epoxy-containing material, poly(*p*-vinylphenol), biphenyl-phenol resin and other resin binders. Most typically, the resin composition does not contain such a novolak resin.

In the resin compositions of the present invention, the weight ratio of a mixture of the epoxy-containing materials to the total weight of the poly(*p*-vinylphenol), the biphenyl-phenol resin and additional resin binder ([total weight of the epoxy-containing materials]:[total weight of the poly(*p*-vinylphenol), the biphenyl-phenol resin and additional resin binder]) is typically in the range of 0.5:1 to 2:1, and more typically 0.7:1 to 1.6:1.

The negative-type photosensitive resin compositions of the present invention contain a photoactive component such as a photo-acid-generating agent which can generate an acid on being exposed to an activating radiation. Any photo-acid-generating agent known in the art can be used in the present invention. Typically, the photo-acid-generating agent is an onium salt. The photo-acid-generating agent may be, for example, an onium salt having a weak nucleophilic anion. The anion may be a halogen complex anion of divalent to heptavalent metal or nonmetal, such as Sb, Sn, Fe, Bi, Al, Ga, In, Ti, Zr, Sc, D, Cr, Hf, and Cu as well as B, P, and As. Examples of suitable onium salts include diaryl diazonium salts, and onium salts of group Va, group Vb, group la, group Ib, and group I elements in a periodic table, such as halonium salts, for example, iodonium salts typical of which are those formed from aryliodoso tosylate and aryl ketone as described in U.S. Patent No. 4,683,317, aromatic iodonium and iodoxonium salts, quaternary ammonium, phosphonium and arsonium salts, aromatic sulfonium and sulfoxonium or selenonium salts. As the photo-acid-generating agent, onium salts can be prepared by methods known in the art. Alternatively, commercially available products, such as triallylsulfonium hexafluorophosphate, may be used.

The photo-acid-generating agent may be a nonionic organic compound. Typical nonionic organic acid-generating agents include a halogenated nonionic compound, such as 1,1-bis(*p-*chlorophenyl)-2,2,2-trichloroethane (DDT); 1,1-bis(*p*-methoxyphenyl)-2,2,2-trichloroethane) (METHOXYCHLOR); 1,2,5,6,9,10-hexabromocyclododecane; 1,10-dibromodecane; 1,1-bis(*p-*chlorophenyl)-2,2-dichloroethane; 4,4'-dichloro-2-(trichloromethyl)benzhydrol, 1,1-bis(chlorophenyl)-2,2,2-trichloroethanol (KELTHANE); hexachlorodimethylsulfone; 2-chloro-6-(trichloromethyl)pyridine; O,O-diethyl-O-(3,5,6-trichloro-2-pyridyl)phosphorothioate (DURSBAN); 1,2,3,4,5,6 hexachlorocyclohexane; *N*-1,1-bis(*p*-chlorophenyl)-2,2,2-trichloroethylacetamide, tris(2,3-dibromopropyl) isocyanurate; 2,2-bis(*p-*chlorophenyl)-1,1-dichloroethylene; as well as the isomers, analogs and homologues of these compounds. Among the above materials, tris(2,3-dibromopropyl) isocyanurate is typical. Suitable photo-acid-generating agents are also described in European patent publication No. 0232972.

The negative-type photosensitive resin compositions of the present invention contain a sufficient amount of the photo-acid-generating agent to develop the coating film of the composition, after being exposed to activating radiation and optional post-exposure baking.

In addition to the components described above, the negative-type photosensitive resin composition of the present invention may also optionally comprise a crosslinking agent. Examples of suitable crosslinking agent include amine-based materials, such as melamine crosslinking agents, benzoguanamine crosslinking agents, and urea crosslinking agents. The melamine crosslinking agents include melamine monomers, melamine oligomers, and melamine polymers; various resin materials such as melamine-formaldehydes. The benzoguanamine crosslinking agents include, for example, benzoguanamine-formaldehyde. The urea crosslinking agents include, for example, urea-formaldehyde and glycoluril-formaldehyde resins. The crosslinking agents which are amine-based materials, such as melamine crosslinking agents, benzoguanamine crosslinking agents, and urea crosslinking agents may be used in combination with optional crosslinking agents. In one exemplary embodiment, the crosslinking agents are a combination of a melamine crosslinking agent and a urea crosslinking agent. Suitable amine-based crosslinking agents include melamines such as CYMEL 300, 301, 303, 350, 370, 380, 1116, and 1130 (registered trademark, American Cyanamid Company, Wayne, NJ, USA), benzoguanamines such as CYMEL 1123 and 1125, glycoluril resins such as CYMEL 1170, 1171, 1172 and 1174, and urea-based resins such as BEETLE 60, 65, and 80. Other similar amine-based compounds are commercially available.

Among the amine-based crosslinking agents described above, typical are melamine resins, glycoluril resins, and combinations thereof. Suitable crosslink agents include melamine-formaldehyde resins, which are reaction products of melamine and formaldehyde, or glycoluril resins substituted by alkoxyalkyl groups. The melamine-formaldehyde resins are generally ethers, such as trialkylolmelamine or hexaalkylolmelamine. The alkyl group may contain 1-8 or more carbon atoms, with methyl being typical. Depending on the reaction conditions and the concentration of formaldehyde, the methyl ethers may be used to react with each other in order to form more complicated units.

Optionally, the negative-type photosensitive resin composition used in the present invention may contain a photosensitizer. The photosensitizer is added to the composition in a sufficient quantity to increase wavelength photosensitivity. Suitable photosensitizers include, for example, 2-ethyl-9,10-dimethoxyanthracene, 9,10-dichloroanthracene, 9,10-phenylanthracene, 1-chloroanthracene, 2-methylanthracene, 9-methylanthracene, 2-*t*-butylanthracene, anthracene, 1,2-benzanthracene, 1,2,3,4-dibenzanthracene, 1,2,5,6-dibenzanthracene, 1,2,7,8-dibenzanthracene, and 9,10-dimethoxydimethylanthracene, *N*-methylphenothiazine and isopropylthioxanthone. Of these, 2-ethyl-9,10-dimethoxy-anthracene, *N*-methylphenothiazine and isopropylthioxanthone are typical.

Optionally, the negative-type photosensitive resin compositions of the present invention may contain additional additives, including dyes, fillers, wetting agents, flame retardants, leveling agents, and silane coupling agents. When the compositions of the present invention are applied onto a silicon substrate, it is typical that a silane coupling agent is used to improve affinity with the silicon substrate.

The concentrations of the additives, which may be employed in the negative-type photosensitive resin compositions of the present invention, are suitably determined by one skilled in the art depending on materials to be used, applications of the composition, and substrate type. There is no particular limitation on the concentrations of the additives.

The negative-type photosensitive resin compositions of the present invention may also contain a suitable solvent capable of dissolving the components described above. There is no particular limitation on such a solvent, as long as the solvent is able to adequately dissolve the components present in the composition. Any solvent known in the art may be used for this purpose. Suitable solvents include, but are not limited to, one or more glycol ethers such as ethylene glycol monomethyl ether, propylene glycol monomethyl ether, dipropylene glycol monomethyl ether; esters such as methylcellosolve acetate, ethylcellosolve acetate, 1-methoxy-2-propyl acetate, propylene glycol monomethyl ether acetate, dipropylene glycol monomethyl ether acetate; dibasic esters; propylene carbonate; gamma-butyrolactone; and alcohols such as *n-*propanol.

The negative-type photosensitive resin compositions of the present invention may be prepared by dissolving the components described above in the solvent. The solid concentration of these components in the negative-type photosensitive resin composition is suitably determined, depending on various factors such as application process of the resin composition, and components to be used. Generally, the solid concentration may be about 10-70 % by weight or higher, based on the total weight of the negative-type photosensitive resin composition. More particularly, when the resin composition is used for flow coating, the solid concentration may be about 40-50 % by weight or higher, based on the total weight of the composition.

A further aspect of the present invention provides a method of forming a patterned insulating layer. The method involves forming a film on a substrate, the forming comprising applying the negative-type photosensitive resin composition of the invention to the substrate, exposing the film and developing the exposed film to form a patterned insulating layer. The resin composition can be applied onto a substrate by conventional methods including, but not limited to, screen printing, flow coating, roller coating, slot coating, spin coating, curtain coating, static spraying, spray coating, and dip coating, or by applying the composition as a dry film. The viscosity of the photosensitive resin composition can be adjusted to a suitable range by adding a solvent to decrease the viscosity or by adding a thickener or filler to increase the viscosity so that the viscosity of the resin composition meets the requirements of each process. The thickness of the coated film of the resin composition applied to the substrate may be adjusted as desired, and there is no particular limitation on the thickness of the coated film.

As the substrate used in the method of the present invention, a substrate having any shape and any material may be used, as long as the resin pattern can be formed on the substrate. Exemplary materials for the substrate include, but are not limited to, resins, ceramics, metals, glasses and semiconductors. Substrates including a resin material include, for example, printed circuit boards and semiconductor packages. Substrates including a ceramic material include, for example, semiconductor packages. Copper is a typical metal used in the substrate, for example, in copper boards. Suitable glass substrates include, for example, display materials, such as liquid crystal displays (LCDs) and flat panel displays (FPDs). The substrate can be formed by a combination of an insulating material and a conducting material, for example, a substrate with a conducting metal pad on a resin. In addition, a silicon wafer substrate, for example, a silicon wafer having a metal layer such as a sputtered copper film formed thereon may be suitable.

After the coating step, the film may be dried to remove any solvent. If desired, a soft bake step may be carried out by heating to evaporate the solvent from the coated resin composition. The temperature and time are appropriately set in the soft bake step.

In the exposure step, the resin composition film is irradiated with activating radiation. There is no particular limitation for the radiation source used in the exposure step. Typically, radiation in the form of a light beam at 436 nm, 405 nm, 365 nm, and 254 nm from a mercury lamp or at 157 nm, 193 nm, 222 nm, and 248 nm from an excimer laser are suitable for this purpose. The light beam can be monochromatic or polychromatic. Moreover, a phase shift method may also be used in the exposure step. When the resin composition film is irradiated with a patterned activating radiation, the pattern is transferred to the composition film.

After exposure, a post exposure bake (PEB) may be carried out, by methods known in the art under suitable conditions. For example, the post exposure bake (PEB) can be suitably carried out using a hot plate at about 70-140°C for about 15 seconds to 10 minutes. Instead of using a hot plate, a convection oven may be used. In this case, a longer treatment time may be required as compared to the hot plate.

In the developing step, the substrate coated with the resin composition is contacted with a developer. Developers known in the art may be used at a suitable concentration. Suitable developers include, for example, alkaline developers selected from aqueous solutions of inorganic alkaline such as potassium hydroxide, sodium hydroxide, sodium carbonate, potassium carbonate, sodium silicate, sodium metasilicate, aqueous ammonia; primary amines such as ethylamine, *n*-propylamine; secondary amines such as diethylamine, di-*n*-propylamine; tertiary amines such as triethylamine, trimethylamine; and quaternary ammonium salts such as tetramethylammonium hydroxide (TMAH), trimethylhydroxyethyl-ammonium hydroxide. Aqueous TMAH solutions at a concentration of 1-10 % by weight, for example, 2-5 % by weight are typical. The resin compositions of the invention have the advantage in that they can be developed with an aqueous TMAH solution, which is a common developer for photoresists. If desired, the developer may also contain an alcohol, surfactant, and the like. Moreover, it may be beneficial if the resin composition and developer are filtered through a microfilter in order to remove dust before use.

The resin compositions of the present invention can be used not only in manufacturing WL-CSPs and ultra LSIs, but also in fabricating general ICs, masks, printing plates such as planographic plates, engraved plates, and relief printing plates. In addition, the resin compositions can be used as photoresists such as for printed circuit boards, interlayer insulating resins, solder resists, color filters for liquid crystal display devices, photo-hardening inks, paints and adhesives, and can be used in forming or duplicating a relief image. Particularly, the negative-type photosensitive resin compositions of the invention are very useful as interlayer insulating layers for manufacturing WL-CSPs and semiconductor circuits.

The present invention is explained further in detail in the following examples. However, these examples should not be understood to limit the scope of the present invention.

### EXAMPLES

### Examples 1-5 and Comparative Example 1

For Examples 1-5 and Comparative Example 1, the negative-type photosensitive resin compositions shown in Table 1 were prepared. Resin patterns were formed and tested for each of the compositions using the Resin Pattern Formation Test described below. The results of the Resin Pattern Formation Test are set forth in Table 1.

### Resin Pattern Formation Test

Step 1: The negative-type photosensitive resin composition is applied on a silicon wafer using a spin coater to form a coating film with a dried thickness of 12 micrometers.

Step 2: The substrate coated with the negative-type photosensitive resin composition is heated in a convection oven at 90°C for 30 minutes.

Step 3: The substrate is covered with a quartz mask having a printed chromium pattern, and exposed with UV light generated by a high pressure mercury lamp (including i-line, g-line, and h-line) at a dose of radiation of 1000 mJ/cm² of i-line.

Step 4: The exposed substrate is heated in a convection oven at 80°C for 40 minutes as a post-exposure bake.

Step 5: Development is carried out by dipping the substrate in 2.38 % by weight of an aqueous TMAH solution at 23°C for 2.5 minutes. Formation of the resin pattern is confirmed by visual inspection.

In Table 1, the symbols used for "TMAH development performance" are as follow:
- "O" =: The photosensitive resin composition film was completely developed.
- "Δ" =: Only the surface of the photosensitive resin composition film was developed and residual film was observed.
- "X" =: The photosensitive resin composition film was not developed at all.

The components listed in Table 1 are as follows:
Poly(*p*-vinylphenol) (MARUKA LYNCUR M S4P, Maruzen Petrochemical Co.);
Biphenyl-phenol resin (softening point: 79°C, OH equivalence: 207 g/eq) (Phenol Resin MEH-7851M, Meiwa Kasei Co.);
Bisphenol epoxy-containing material (Bisphenol A epoxy resin, EPIKOTE 828, Japan Epoxy Resin Co., Ltd.);
Polyalkyleneoxylated epoxy-containing material (EPICLON EXA 4850-150, Dainippon Ink and Chemicals, Inc.);
Alicyclic epoxy resin (ADEKA RESIN EP-4088S, Asahi denka Co.);
Crosslinking agent: Hexamethoxymethylated melamine (Mitsui Cytec Industries);
Crosslinking agent 2: Tetramethoxymethyl glycoluril (POWDERLINK 1174, Mitsui Cytec Industries);
Photo-acid-generating agent: Triallylsulfonium hexafluorophosphate;
Silane coupling agent: γ-glycidoxypropyltrimethoxysilane (TORAY-Dow Corning Silicone Co., Ltd.);
Photosensitizer: 2-ethyl-9,10-dimethoxyanthracene; and
PGMEA: Propylene glycol monomethyl ether acetate.

In addition, a test for evaluating thermal shock resistance for the compositions of Examples 1-4 and Comparative Example 1 was conducted using the Thermal Shock Test described below. The results of the Thermal Shock Test are set forth in Table 1. This test involved use of a cured composition in the form of a bilayer sample with a 2 mm square window pattern on a BT resin. The thermal shock test (from -65°C/7 minutes to 150°C/7 minutes) was carried out in a liquid phase.

### Thermal Shock Test

Step 1: The negative-type photosensitive resin composition is applied on BT resin with a spin coater to form a film having a dried thickness of 30 micrometers (the first layer).

Step 2: The coated substrate is heated in a convection oven at 90°C for 30 minutes.

Step 3: The composition on the substrate is exposed with UV light generated by a high pressure mercury lamp (including i-line, g-line, and h-line) at a dose of radiation of 3000 mj/cm² of i-line. This exposure is carried out without patterning.

Step 4: The exposed substrate is heated in a convection oven at 80°C for 40 minutes as a post-exposure bake.

Step 5: The substrate is heated in a convection oven at 130°C for 30 minutes as a precuring treatment.

Step 6: The substrate is heated in a convection oven at 200°C for 1 hour as a heat-curing treatment.

Step 7: The heat-curing treated first layer is treated with UV ozone to modify its surface.

Step 8: The same negative-type photosensitive resin composition used for the first layer is applied on the surface-modified first layer with a spin coater to form a film having a dried thickness of 30 micrometers (the second layer).

Step 9: The coated substrate is heated in a convection oven at 90°C for 30 minutes.

Step 10: The substrate is covered with a quartz mask having a printed chromium pattern and exposed with UV light generated by a high pressure mercury lamp (including i-line, g-line, and h-line) at a dose of radiation of 3000 mJ/cm² of i-line. A 2 mm square window pattern is formed by the exposure.

Step 11: The exposed substrate is heated in a convection oven at 80°C for 40 minutes as a post-exposure bake.

Step 12: The substrate is developed by dipping in a 2.38 % by weight aqueous TMAH solution at 23°C for 3 minutes, and is then washed with distilled water.

Step 13: The substrate is heated in a convection oven at 130°C for 30 minutes as a precuring treatment.

Step 14: The substrate is heated in a convection oven at 200°C for 1 hour as a heat-curing treatment.

Step 15: The substrate is repeatedly thermally cycled at -65°C for 7 minutes to 150°C for 7 minutes in a liquid phase until cracking of the cured resin is observed.

**Table 1**

| **Component** | **Example No.** | | | | | |
|---|---|---|---|---|---|---|
| | **1** | **2** | **3** | **4** | **5** | **Comp. 1** |
| Poly(*p*-vinylphenol) (g) | 17.2 | 17.6 | 18.1 | 18.5 | 18.8 | 18.8 |
| Biphenyl-phenol resin (g) | 5.7 | 5.9 | 4.5 | 4.6 | 6.3 | 6.3 |
| Bisphenol epoxy-containing material (g) | 23.6 | 20.1 | 23.8 | 20.3 | 21.5 | 28.8 |
| Polyalkyleneoxylated epoxy-containing material (g) | 7.9 | 6.7 | 7.9 | 6.8 | 7.2 | 0 |
| Alicyclic epoxy resin (g) | 0 | 4 | 0 | 4.1 | 0 | 0 |
| Photo-acid-generating agent (g) | 3.5 | 3.6 | 3.5 | 3.6 | 3.9 | 3.8 |
| Crosslinking agent (g) | 2.6 | 2.7 | 2.6 | 2.7 | 2.8 | 3.5 |
| Crosslinking agent 2 (g) | 0.6 | 0.7 | 0.7 | 0.7 | 0.7 | 0 |
| Silane coupling agent (g) | 1.1 | 1.1 | 1.1 | 1.1 | 1.1 | 1.1 |
| Photosensitizer (g) | 0.4 | 0.4 | 0.4 | 0.4 | 0.4 | 0.4 |
| PGMEA (g) | 37.1 | 37.1 1 | 37.1 1 | 37.1 1 | 37.1 | 37.1 |
| TMAH development performance | O | O | O | O | O | O |
| Thermal Shock Resistance (cycles) | 400 | 500 | 400 | 300 | - | 150 |

The photosensitive resin compositions of Examples 1-5 and Comparative Example 1 (Comp. 1) were completely developed by the 2.38 % TMAH solution. Also, an increase in the content of the epoxy resin combinations did not affect development performance after the exposure step.

Regarding the Thermal Shock Test, the cured resin prepared from the photosensitive resin composition of Comparative Example 1 resulted in cracking after only 150 cycles. The photosensitive resin compositions of Examples 1-4 resulted in no cracking until 300 to 500 cycles.

## Claims

1. A negative-type photosensitive resin composition, comprising:
a vinylphenol resin;
a biphenyl-phenol resin; and
two or more epoxy-containing materials.

2. The negative-type photosensitive resin composition according to claim 1, wherein the epoxy-containing materials comprise a bisphenol epoxy-containing material and a polyalkyleneoxylated epoxy-containing material.

3. The negative-type photosensitive resin composition according to claim 1, wherein the epoxy-containing materials comprise a bisphenol A, a polyalkyleneoxylated and an alicyclic hydrocarbon epoxy-containing material.

4. The negative-type photosensitive resin composition according to claim 1, wherein the vinylphenol resin is a poly(*p*-vinylphenol) resin.

5. The negative-type photosensitive resin composition according to claim 1, further comprising a crosslinking agent.

6. The negative-type photosensitive resin composition according to claim 5, wherein the crosslinking agent comprises a melamine crosslinking agent and a urea crosslinking agent.

7. A method of forming a patterned dielectric film, comprising:
(a) forming a film on a substrate, the forming comprising applying a negative-type photosensitive resin composition to a substrate, wherein the composition comprises a vinylphenol resin, a biphenyl-phenol resin and two or more epoxy-containing materials;
(b) exposing the film; and
(c) developing the exposed film to form a patterned dielectric film.

8. The method according to claim 7, wherein the epoxy-containing materials comprise a bisphenol epoxy-containing material and a polyalkyleneoxylated epoxy-containing material.

9. The method according to claim 7, wherein the epoxy-containing materials comprise a bisphenol A, a polyalkyleneoxylated and an alicyclic hydrocarbon epoxy-containing material.

10. The method according to claim 7, wherein the vinylphenol resin is a poly(*p*-vinylphenol) resin.
